# EUROPEAN PATENT APPLICATION

(11) **EP 2 395 043 A1**
(43) Date of publication of application: **14.12.2011**
(21) Application number: 10005170.5
(22) Date of filing: 18.05.2010
(51) Int. Cl.: C08J 3/215, C08K 3/04, H01B 1/24, C08J 5/00, H01L 51/00

(54) **Polymer composition comprising graphene**

(71) Applicant: Stichting Dutch Polymer Institute, 5612 AB Eindhoven (NL)
(72) Inventor: The designation of the inventor has not yet been filed
(74) Representative: Renkema, Jaap

(57) **Abstract**

The present invention relates to a process for the preparation of a polymer composition comprising a polymer and graphene, comprising the steps of: A) providing an aqueous dispersion of graphene, the dispersion comprising a non-ionic surfactant; B) mixing the dispersion of graphene with an aqueous latex of the polymer or (a) water-soluble or dispersible precursor(s) of the polymer; C) removing water from the so obtained mixture; D) heating the product from step C) to a temperature at which the polymer flows or where the polymer is formed from its precursor(s); and E) processing and/or solidifying the product of step D) into a desired form.

## Description

The present invention relates to a process for the preparation of a polymer composition comprising graphene and the articles obtained by this process.

Polymer compositions comprising graphene (also called graphene sheets) are presently obtained In two ways from pristine graphite. Pristine graphite consists of stacks of graphene sheets. The individual graphene sheets are predicted to have a range of unusual properties. Recent studies have shown that individual graphene sheets have extraordinary electronic transport properties.

In order to harness these properties for applications the graphene sheets have to be incorporated and homogeneously distributed into the polymer matrix. Although pristine graphite Is inexpensive and readily available, it unfortunately does not easily exfoliate to yield individual graphene sheets.

Stankovich et al. (Nature, vol. 442, 20 July 2006, 282-286) show a first way to obtain polymer composition comprising graphene. Stankovich first oxidizes the pristine graphite Into graphite oxide, making use of the Hummers method. Subsequently they use a general approach to exfoliate and chemically modify the graphite oxide In the presence of organic isocyanates. Next they reduce the obtained product by N,N dimethylhydrazine in the presence of polystyrene. By means of filtration, washing, drying, crushing and pressing they prepare a conductive polystyrene composition, comprising graphene, exhibiting a percolation threshold of ∼0.1 volume percent graphene for room-temperature electrical conductivity. At only 1 volume percent graphene this composition has a conductivity of ∼0.1 S/m, sufficient for electrical applications.

Hernandez et al. (Nature nanotechnology, vol. 3, September 2008, 563-568) show a second way to obtain polymer compositions, comprising graphene. Hernandez uses liquid-phase exfoliation of pristine graphite in inorganic solvents such as N-methyl-pyrrolidone to produce individual graphene sheets in concentrations up to ∼0.1 mg/ml. By adding polystyrene to the graphite dispersion In N-methyl pyrrolidone, subsequent sonication for 15 minutes and vacuum filtration, composite films were obtained. These conductive polystyrene composite films have high volume-fractions of graphene sheets. At 60-80 volume percent of graphene sheets In the composite films they measured conductivities of ∼100 S/m.

There is a constant need for compositions which can be used for a wide range of applications. It is an object of the present invention to provide such polymer compositions and a process to make such polymer compositions.

The present invention provides a process for the preparation of a polymer composition comprising a polymer and graphene, comprising the steps of:
A) providing an aqueous dispersion of graphene, the dispersion comprising a non-Ionic surfactant;
B) mixing the dispersion of graphene with an aqueous latex of the polymer or (a) water-soluble or dispersible precursor(s) of the polymer;
C) removing water from the so obtained mixture;
D) heating the product from step C) to a temperature at which the polymer flows or where the polymer Is formed from its precursor(s); and
E) processing and/or solidifying the product of stop D) into a desired form.

The inventors have realized that the use of the non-ionic surfactant allows the dispersion of graphene to be mixed with a wide range of aqueous latexes in the subsequent step. There is no limitation in the type of any surfactant used for stabilizing the aqueous latex. The surfactant for the aqueous latex may be cationic, anionic or non-ionic, In comparison, mixing a dispersion of graphene stabilized by an Ionic surfactant with an aqueous latex stabilized by an oppositely-charged ionic surfactant will result in a formation of complexes and coagulation.

Step A): Preferably, the non-ionic surfactant is chosen from the group consisting of a a polyoxyethylene sorbitan fatty acid ester (polysorbate), a block copolymer of polyethyleneglycol and polypyrrole, a block copolymer of polyethylene glycol and polystyrene and a combination thereof. The polyoxyethylene sorbitan fatty acid ester may be a polyoxyethylene sorbitan fatty acid ester in which the fatty acid contains 8 to 22 carbon atoms, preferably 12-18 carbon atoms and most preferably 18 carbon atoms and the number of oxyethylene units is 5-40, preferably 10-30, most preferably 20. Most preferable polyoxyethylene sorbitan fatty acid ester include polyoxyethylene (20) sorbitan monolaurate, polyoxyethylene (20) sorbitan monopalmitate, polyoxyethylene (20) sorbitan monostearate, polyoxyethylene (20) sorbitan monooleate and a combination thereof. Polyoxyethylene (20) sorbitan monooleate is particularly preferred. The use of polysorbate is advantageous in that it is a cell compatible material. Thus the polymer composition according to this embodiment is useful for the production of biocompatible materials. Furthermore, polysorbate is not porous and thus less hygroscopic than many other (especially Ionic) surfactants. This makes It more favourable for the mechanical properties of the final polymer composition, especially in humid environments. The block copolymer of polyethyleneglycol and polypyrrole is water dispersible, and can stabilize a dispersion of graphene in water. The polypyrrole is electrically conductive, which may build conductive bridges between the graphene platelets and lower the contact resistivity.

In a first group of embodiments of the present invention, providing the aqueous dispersion of graphene involves use of graphene obtained by thermal reduction of graphite oxide. In these embodiments, step A) comprises (a1) adding graphene obtained by thermally reducing graphite oxide to an aqueous medium comprising the non-ionic surfactant and (a2) sonicating the resulting product of (a1). The thermal reduction may be performed by heating the graphite oxide to about 1050 °C within about 30 seconds. Such a rapid heating exfoliates as well as reduces graphite oxide, yielding a black powder. This black powder can be dispersed by means of sonication. The weight ratio between the non-Ionic surfactant and graphene is preferably at least 2:1, When the ratio of the non-Ionic surfactant is too low, the dispersion is not stable. The weight ratio between the non-ionic surfactant and graphene Is preferably at most 10:1, more preferably at most 5:1, most preferably at most 3:1. When the ratio of the non-ionic surfactant Is too high, the conductivity of the polymeric composition becomes too low to be suitable for some applications. The concentration of graphene in the aqueous dispersion Is preferably at most 1mg/ml.

In step (a2), sonication Is preferably done by ultrasound. Exposure to this ultrasonic treatment needed for an effective exfoliation of the graphene sheets can be easily determined by a man skilled in the art by routine experiments. For example, sonication of at least 1 hour (total energy of 1200 Joules) may be performed per mg of graphene to obtain a good dispersion. Preferably, sonication is performed for 2-6 hours (total energy of 2400-4800 Joules) per mg of graphene. A particularly preferred sonication for 200 ml of an aqueous dispersion with a graphene concentration of 1 mg/ml is 3 hours with a total of 720,000 Joules.

This first group of embodiments provides a very simple way of obtaining the desired dispersion without the use of a reducing agent and thus the final polymer composition.

It was found that the black powder obtained after the thermal treatment typically consists of hundreds of stacked graphene layers. In such cases, the exfoliation is not complete. The sonication step exfoliates the stacks. If large particles of stacked graphenes still remain after the sonication step, they may be removed by centrifugation. Similarly, In the case sedimentation occurs after a prolonged time after making the dispersion, they can be removed by centrifugation before mixing the dispersion with the aqueous latex in the subsequent step.

In the second group of embodiments of the present invention, providing the aqueous dispersion of graphene involves reducing graphite oxide by reducing agents. In these embodiments, step A) comprises (b1) providing an aqueous dispersion of graphite oxide, (b2) adding ammonia and the non-ionic surfactant to the aqueous dispersion of graphite oxide and (b3) reducing the graphite oxide in the dispersion obtained by (b2) to graphene by a reducing agent..

Step (b1) may be performed by sonicating an aqueous medium containing graphite oxide, preferably by ultrasound. Exposure to this ultrasonic treatment needed for an effective exfoliation of the graphene sheets can be easily determined by a man skilled in the art. In the second group of embodiments, the ultrasonic treatment can generally be performed in less than 1 hour and with less than 40,000 J for 200ml of a dispersion containing 200mg of graphene. In general, at least 1 minute and 6 J is desirable for proper dispersion per mg of graphene. Sonication is performed more preferably at least 5 minutes and 25 J per mg of graphene, and most preferably at least 10 minutes and 7000 J.. Performing dialysis during step (b1) was found to be particularly useful for obtaining a good aqueous dispersion of graphene. Dialysis may be performed on the sonicated aqueous dispersion of graphite oxide, and the dialyzed graphite oxide may again be subjected to a sonication. The sonication after dialysis may be advantageous for breaking up any aggregates which may have formed during the dialysis step.

In step (b2), the order of addition of ammonia and the non-ionic surfactant is not critical, I.e. ammonia may be added before the addition of the non-ionic surfactant, and vice versa. Step (b2) should not be performed under a raised temperature and/or an extended time which would result in the reduction of the graphite oxide.

In step (b3),The reducing agent reduces the graphite oxide to graphene, making it very hydrophobic. If the non-Ionic surfactant is not present in this step, the formed graphene will gradually agglomerate. This agglomeration turned out to be Irreversible as was described in the publication of Stankovich *et al*. It was also found out that adding graphite oxide to an aqueous medium without ammonia resulted in Irreversible aggregation upon reduction. Thus the combination of the non-ionic surfactant and ammonia was found to be crucial for the second group of embodiments of the present invention.

Reducing agents which can be used are those capable of reducing graphite oxide to graphene, wherein the graphene sheets have conductive properties. Known reduction agents for this purpose are hydrazine and its derivates, such as N,N-dimethylhydrazine and hydrazine. Hydrazine is preferred.

The reduction agents may be added in either a diluted form or a non-diluted form. Solvents such as DMF may be used as diluents.

It was found that polyoxyethylene (20) sorbitan monooleate is particularly preferred as the non-Ionic surfactant for obtaining a good dispersion which can be used for obtaining the final polymer composition having a high conductivity.

In the second group of embodiments, the reduction is performed at reaction temperatures typically between 80 °C and 180 °C during step (b3). Preferably the reduction step is performed at reaction temperatures between 105 °C and 150 °C, more preferably between 110 °C and 150 °C, and most preferably between 80 °C and 100 °C.

In the second group of embodiments, the process of the present invention keeps the duration of the reduction step between 10 and 200 hours during the step b3) when the reaction temperature is kept constant. Preferably the reduction step lasts between 20 and 150 hours, more preferably between 30 and 120 hours and most preferably between 40 and 100 hours..

In the second group of embodiments, the graphite oxide is preferably added to the aqueous medium to a concentration of between 0.025 and 0.25 mg/ml, more preferably between 0.05 and 0.1 mg/ml. The weight ratio between the non-ionic surfactant and the graphite oxide is preferably between 3:1 and 3:2. For ensuring that a good dispersion is obtained after a long reduction time, the weight ratio between the non-ionic surfactant and the graphite oxide is preferably between 3:1 and 2:1. For obtaining a higher conductivity in the final polymer composition, the weight ratio between the non-Ionic surfactant and the graphite oxide is preferably between 2:1 and 3:2. The amount of the reducing agent is preferably 5-200 mmol per gram of graphene oxide, more preferably 8-12, most preferably 10-11.5 mmol per gram of graphene oxide.

Also with the second group of embodiments, any sedimentation can be removed by centrifugation before mixing the dispersion with the aqueous latex in the subsequent step.

In the process of the present invention the use of graphite oxide is preferred, as graphite oxide is hydrophilic In nature and therefore readily dispersed in an aqueous medium. Moreover graphite oxide is easily obtained by the oxidation of pristine graphite using the Hummers method (*Hummers W, Offerman R. Preparation of graphite oxide; J. Am. Chem, Soc., 1958*, *80:1339).*

Step B): The dispersion of graphene is mixed with an aqueous latex of a polymer. This polymer is the polymer which constitutes the matrix of the final polymer composition, in which the graphene sheets are well-dispersed. Every aqueous polymer latex known to the skilled man can be used. The latex may be either a high molecular weight latex, or a latex with a bimodal distribution of low and high molecular weight. In the case the bimodal distribution is used, the low MW fraction may help to facilitate processing in steps D and E and help to make the matrix materials to flow well and wet the surface and generate the most optimum network. Preference is given to a polymer being selected from the group consisting of poly(meth)acrylatas, styrene-based (co-)polymers, butadiene-based (co)polymers, polyurethane, polyvinylchloride, polycarbonate, acrylonitrile-based (co-)polymers, (halogen-containing) polyolefins (like polyethylene or polypropylene), polydimethylsiloxane, and polyamides. The aqueous latex may be stabilized by a cationic, anionic or non-Ionic surfactant.

Also (a) precursor(s) for such a polymer can be used as such, or in the form of an aqueous solution thereof which can be converted to the polymer via an emulsion polymerization. Preference can be given, for instance when a nylon is used as the polymer, to the use in this step B) of either the monomer of said polymer (like ε-caprolactam when using nylon 6 as the final matrix material), or to the use of a salt of adipic acid and hexamethylene diamine, or diaminobutane, when nylon 6,6 or nylon 4,6 as the matrix material Is aimed at. The skilled man Is aware of the precursor(s) needed for such a polymer. A preference is given to the use in this step B) of ((a) precursor(s) of) a polyamide or a polystyrene based polymer.

The temperature of this step B) generally lies between 10 and 150°C. The pressure is generally atmospheric, but may be increased in order to accommodate for processability In this step B) or in the following step C). The residence time for this step B) is not critical, and generally does not exceed 1 hour.

Although both thermoset polymers as well as thermoplastic polymers can be used as the matrix of the polymer composition, the preference is given to the use of a (semi-) crystalline or amorphous thermoplastic polymer.

Step C): the mixture obtained in process step B), according to the present invention, is treated to remove (substantially all of the) water. There are different physical methods available to the skilled man to achieve this removal. Out of these methods, a preference is for performing step C) by means of evaporation, freeze-drying, or flash-drying.

Step D): Is Intended to realize a homogeneous dispersion of the graphene sheets in the polymer. When in the preceding steps use is made of (a) precursor(s) for this polymer, this step D) is also intended to form the polymer from this/these precursor(s). In the case that the polymer is a thermoplastic polymer, the temperature in this step D) is chosen such that it is 10-100°C above the melting point (In case of a (semi-)crystalline polymer), or above the glass point (in case of an amorphous polymer). In the case that the polymer is a thermoset polymer, the temperature In this step D) is chosen such that this polymer can be formed from its precursor(s), during which formation also step E) of the process of the present invention is applied.

In all cases, the man skilled in the art is aware of the process conditions under which this step D) is to be performed, depending on the nature of the second polymer.

Step E): of the process of the present invention is the processing and/or solidification of the product of step D) in a desired form. This step E) can be a molding step, a pelletizing step, an injection or compression molding step, or any known step to form a solidified polymer object.

The process of the present invention results in a polymer composition, wherein the properties of the graphene sheets obtained are retained: the graphene sheets are hardly or not damaged, as a result of which they retain their original length as well as their original aspect ratio (AR) (ratio of length to diameter of the graphene sheets). The graphene sheets are essentially individually dispersed or composed of 2-10 layers of graphene in the polymer matrix. The polymer therefore has Improved stiffness as well as better conductivity properties.

The invention also relates to a polymer composition comprising graphene obtainable by the process of the present invention. With the process of the present invention polymer compositions are obtainable having a conductivity of 0.1 to 3 S/m at graphene loadings between 2 and 10 wt% relative to the total composition.

The polymer composition comprising graphene of the present invention can be used for several applications In which its mechanical or gas barrier properties can be exploited and also properties like for example conductivity, flame retardancy and heat conductivity.

According to another aspect of the invention, the present invention relates to a dispersion of graphene in an aqueous solution of a non-ionic surfactant. Such a dispersion may advantageously used for making a polymer composition as described above. Preferably, the non-ionic surfactant is chosen from the group consisting of a polysorbate, a block copolymer of polyethyleneglycol and polypyrrole and a combination thereof. Particularly preferred non-Ionic surfactant is chosen from the group consisting of polyoxyethylene (20) sorbitan monolaurate, polyoxyethylene (20) sorbitan monopalmitate, polyoxyethylene (20) sorbitan monostearate, polyoxyethylene (20) sorbitan monooleate and a combination thereof.

The invention is further illustrated by the following non-limiting examples.
Figure 1 shows the result of conductivity measurements for an example of the present invention.
Figure 2 shows the result of conductivity measurements for another example of the present invention.

### Experiment 1. Preparation of aqueous dispersion

### Example 1-1

### 1) Preparation of Graphite Oxide (Hummers Method, Hummers W, Offerman R. Preparation of graphitic oxide. J Am Chem Soc 1958; 80:1339)

The graphite oxide was prepared by stirring 1 g of graphite powder and 0.5 g of sodium nitrate In 25 ml of concentrated sulfuric acid. The ingredients were mixed and then 3 g of potassium permanganate were added to the suspension. As the reaction progressed the mixture became brownish-grey in color. At the end of 2 hours, 45 mL of water was slowly added causing the temperature to increase from room temperature value to 90-100 °C. The diluted suspension, brown In color, was maintained at this temperature for 15 minutes. Then the suspension was further diluted to 200 mL with hot water and treated with hydrogen peroxide. Upon treatment with hydrogen peroxide the suspension turned bright yellow. The suspension was filtered resulting in a yellow-brown filter cake. The filtering was conducted while the suspension was still warm. After filtering, the product was washed with water and dried under vacuum.

### 2) Preparation of aqueous dispersion of graphene

200 mg of the dried graphite oxide prepared in the previous step was added to 200 ml of demineralized water and was sonicated using a horn sonicator (20 min., total energy provided 20 000 J). To remove acid and metal residuals present from the oxidation step, the dispersion was dialyzed. The dialysis was performed using a cellulose tube membrane (Mw cutoff 40,000 Dalton, Medicell international Ltd) against purified water from Millipore Super Q System, until the conductivity of the counter phase remained constant for several days.

Sonication was performed again to 200 ml of purified water containing the dialyzed graphite oxide (DGO) (15 min., total energy provided 15 000 J). This was done to break-up any aggregates which might have formed during the dialysis step. The concentration of DGO In water (mg/ml) was 0.026 mg/mL.

Reductions were performed in a 50 ml round bottom flask using an oil bath for heating and a stirring bar at 400 RPM for homogenizing the system. The reaction was performed at 90°C in a closed flask. Ammonia 32% in water (obtained from Merck) and hydrazine monohydrate (obtained from Sigma Aldrich, 98%) were used for these reductions.

Ammonia was added to the aqueous DGO dispersion while stirring so that the ratio between ammonia and graphene oxide was 0.231 mol ammonia per g of graphene oxide. After the addition of the ammonia, a surfactant solution containing polyoxyethylene (20) sorbitan monooleate (TWEEN 80) was added so that the ratio between the surfactant and graphene oxide was 3:2 by weight. This was mixed for a 15 min and hydrazine monohydrate was subsequently added so that the ratio between hydrazine monohydrate and graphene oxide was 10.9 mmol hydrazine monohydrate per g of graphene oxide. The reaction mixture was then slowly heated to 90°C and kept at 90°C. After 3 days of reduction, no aggregate was visible and a good dispersion of graphene was obtained.

### Examples 1-2 - 1-17

Experiments were performed by the same procedure as in Example 1-1 except that the concentration of DGO in water, the amount of ammonia, the type (TWEEN 80 (polyoxyethylene (20) sorbitan monooleate) or TWEEN 20 (polyoxyethylene (20) sorbitan monolaurate) and the amount of the surfactant, the amount of hydrazine monohydrate and the reduction period were respectively chosen as shown in Table 1. Example 1.17 further differed from example 1 in that the dialysis and the second sonication were not performed.

**Table 1**

| Ex. | Graphene oxide concentration (mg/mL) | mol NH₃/g DGO | Surfactant:DGO (weight) | mmol hydrazine / g graphene oxide | Duration of reduction (days) |
|---|---|---|---|---|---|
| | | | | | |
| 1-1 | 0.025 | 0.231 | TWEEN 80 (3:2) | 10.9 | 3 |
| 1-2 | 0.025 | 0.231 | TWEEN 80 (3:2) | 10.9 | 6 |
| 1-3 | 0.025 | 0.231 | TWEEN 80 (2:1) | 10.9 | 2 |
| 1-4 | 0.025 | 0.231 | TWEEN 80 (2:1) | 10.9 | 3 |
| 1-5 | 0.025 | 0.231 | TWEEN 80 (3:1) | 10.9 | 3 |
| 1-6 | 0.1 | 0.231 | TWEEN 80 (2:1) | 10.9 | 1 |
| 1-7 | 0.1 | 0.231 | TWEEN 80 (3:1) | 10.9 | 1 |
| 1-8 | 0.1 | 0.231 | TWEEN 80 (3:1) | 10.9 | 2 |
| 1-9 | 0.1 | 0.231 | TWEEN 80 (3:1) | 10.9 | 3 |
| 1-10 | 0.025 | 0.231 | TWEEN 80 (3:1) | 202.0 | 3 |
| 1-11 | 0.025 | 0.231 | TWEEN 80 (3:1) | 101.0 | 3 |
| 1-12 | 0.025 | 0.231 | TWEEN 80 (3:1) | 50.5 | 3 |
| 1-13 | 0.025 | 0.231 | TWEEN 80 (3:1) | 25.3 | 3 |
| 1-14 | 0.025 | 0.231 | TWEEN 80 (3:1) | 12.6 | 3 |
| 1-15 | 0.025 | 0.231 | TWEEN 20 (2:1) | 10.9 | 3 |
| 1-16 | 0.025 | 0.231 | TWEEN 20 (3:1) | 10.9 | 3 |
| 1-17 | 0.1 | 0.231 | TWEEN 80 (3:1) | 10.9 | 1 |

In each of the examples 1-1 -1-16, no aggregate was visible in the dispersion, or when small aggregates were visible, they were easily removable by centrifugation. In example 1-17, more aggregates were formed, but they were still removable by centrifugation.

### Comparative example

Experiments were performed by the same procedure as in Example 1-1 except that TWEEN 80 was used at a weight ratio between the surfactant and graphene oxide was 2:1 and the duration of the reduction was 1 day, and no ammonia was added before adding the surfactant solution.

Aggregates were formed in the dispersion. The amount of aggregates was too much to be removed by centrifugation.

### Example 1-18

Graphene obtained by heating graphite oxide up to 1050 °C within 30 seconds was added to 200 ml of demineralized water so that the concentration of graphene was 1mg/ml. A surfactant solution containing polyoxyethylene (20) sorbitan monooleate was added so that the ratio between the surfactant and graphene was 2:1 by weight. The mixture was sonicated using a horn sonicator (3 hours, total energy provided 720 000 J).

Some sedimentation occurred after 24 hours. It was removed by centrifugation and a good dispersion of graphene was obtained.

### Experiment 2. Preparation of polymer composition

### Example 2-1

### 3) Preparation of polymer composition comprising graphene

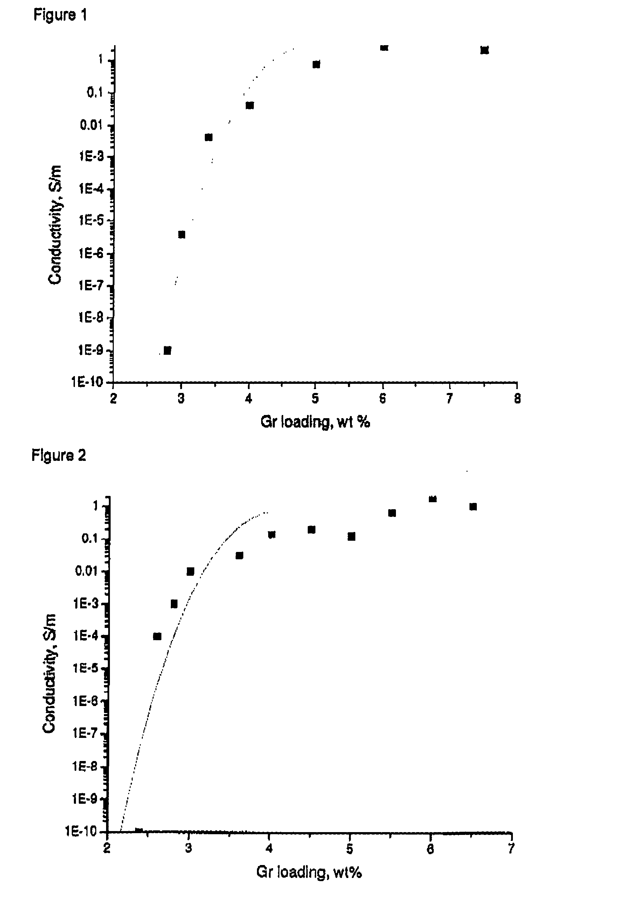

To the graphene dispersion prepared according to example 1-18, different amounts of polystyrene latex (Peak molar mass around 1,000,000 g/mol, 28 % solid content) stabilized by sodiumdodecyl sulphate was added so that the graphene concentration in the double dispersion was varied as shown In Figure 1. The double dispersion was stirred for a few minutes. The mixture of graphene dispersion and latex particles was freeze-dried under vacuum. The resulting powder was degassed and transformed into films by compression molding. The latter consisted of first short heating of the powder to reach the desired working temperature (Starting from 160 °C to 180 °C within 20 min). This heating was followed by a degassing step and two pressings at 40 bars for 20 seconds (at 180°C). The system was finally pressed at 100 bars for 2 minutes at 180 °C.

### 4) Conductivity measurements

Room temperature electrical conductivity measurements were carried out on the polymer composition obtained from step 3) using a standard 4 points configuration DC-Conductivity Keithly Electrometer, Results are plotted against the graphene concentration in Figure 1.

### Example 2-2

Same procedure was followed as in Example 2-1 except that polystyrene latex had a peak molar mass of around 150,000 g/mol and a solid content of 16 %, and that the stabilizer in the polystyrene latex was cetyl trimethylammonium bromide instead of sodiumdodecyl sulphate. Results are shown in Figure 2.

## Claims

1. Process for the preparation of a polymer composition comprising a polymer and graphene, comprising the steps of:
A) providing an aqueous dispersion of graphene, the dispersion comprising a non-ionic surfactant;
B) mixing the dispersion of graphene with an aqueous latex of the polymer or (a) water-soluble or dispersible precursor(s) of the polymer;
C) removing water from the so obtained mixture:
D) heating the product from step C) to a temperature at which the polymer flows or where the polymer is formed from Its precursor(s); and
E) processing and/or solidifying the product of step D) into a desired form.

2. Process according to claim 1, wherein the non-Ionic surfactant is chosen from the group consisting of a a polyoxyethylene sorbitan fatty acid ester, a blockcopolymer of polyethyleneglycol and polypyrrole, a block copolymer of polyethylene glycol and polystyrene and a combination thereof.

3. Process according to claim 1 or 2, wherein the non-ionic surfactant is a polyoxyethylene sorbitan fatty acid ester in which the fatty acid contains 8 to 22 carbon atoms, preferably 12-18 carbon atoms and most preferably 18 carbon atoms and the number of oxyethylene units is 5-40, preferably 10-30, most preferably 20.

4. Process according to any one of claims 1-3, wherein the surfactant is non-ionic surfactant is chosen from the group consisting of polyoxyethylene (20) sorbitan monolaurate, polyoxyethylene (20) sorbitan monopalmitate, polyoxyethylene (20) sorbitan monostearate, polyoxyethylene (20) sorbitan monooleate and a combination thereof.

5. Process according to any of claims 1-3, wherein step A) comprises:
(a1) adding graphene obtained by thermally reducing graphite oxide to an aqueous medium comprising and the non-ionic surfactant and
(a2) sonicating the resulting product of (a1).

6. Process according to claim 4, wherein step (a1) involves heating the graphite oxide to about 1050 °C within about 30 seconds.

7. Process according to any of claims 1-3, wherein step A) comprises:
(b1) providing an aqueous dispersion of graphite oxide,
(b2) adding ammonia and the non-ionic surfactant to the aqueous dispersion of graphite oxide and
(b3) adding a reducing agent to the resulting product of (b2).

8. Process according to 6 or 7, wherein the graphite oxide is added to the aqueous medium to a concentration of at most 0.25 mg/ml.

9. Process according to any one of claims 4-8, wherein the ratio between the the non-ionic surfactant and the graphite oxide is between 2:1 and 10:1.

10. Process according to any one of claims 1-9, wherein the polymer is selected from the group comprising polyacrylates, styrene-based (co-) polymers, butadiene-based (co-) polymers, polyurethane, polyvinylchloride, polycarbonate, acrylonitrile-based (co-) polymers, (halogen-containing) polyolefins, and polyamides.

11. Process according to any one of claims 1-10, wherein the aqueous latex of step B) is stabilized by a cationic, anionic or non-Ionic surfactant.

12. Process according to any of claims 1-11, wherein the amount of graphene In the resulting product from step E) is between 0.1 and 10 % by weight, more preferably 0.5-3 % by weight.

13. Polymer composition obtainable by the process according to any one of claims 1-12.

14. Dispersion of graphene in an aqueous solution of a non-Ionic surfactant.

15. Dispersion of claim 14, wherein the non-ionic surfactant is chosen from the group consisting of polyoxyethylene (20) sorbitan monolaurate, polyoxyethylene (20) sorbitan monopalmitate, polyoxyethylene (20) sorbitan monostearate, polyoxyethylene (20) sorbitan monooleate and a combination thereof.
